Europäisches Patentamt

European Patent Office

Office européen des brevets

(19)

(11) Veröffentlichungsnummer: **0 268 083**
**B1**

(12) **EUROPÄISCHE PATENTSCHRIFT**

(45) Veröffentlichungstag der Patentschrift:
18.04.90

(51) Int. Cl.⁴: **G01R 33/30**

(21) Anmeldenummer: 87115178.3

(22) Anmeldetag: 16.10.87

(54) Oberflächenresonator zur Kernspintomographie.

(30) Priorität: 28.10.86 DE 3636660

(43) Veröffentlichungstag der Anmeldung:
25.05.88 Patentblatt 88/21

(45) Bekanntmachung des Hinweises auf die Patenterteilung:
18.04.90 Patentblatt 90/16

(84) Benannte Vertragsstaaten:
DE FR GB NL

(56) Entgegenhaltungen:
EP-A- 0 135 326
EP-A- 0 160 942
EP-A- 0 187 389
DE-A- 3 237 250

JOURNAL OF MAGNETIC RESONANCE, Band 61, 1985,
Seiten 571-578, Academic Press, Inc., New York, US;
T.M. GRIST et al.: "Resonators for in Vivo 31P NMR
at 1,5 T"
BIOMEDIZINISCHE TECHNIK, Band 31, Nr. 7/8,
Seiten 178-185, Berlin, DE; P. RÖSCHMANN et al.: "Die
Bedeutung der HF-Spulen für die
Kernspintomographie"
MEDICAL PHYSICS, Band 13, Nr. 1,
Januar/Februar 1986, Seiten 1-7, Am. Assoc. Phys. Med.,
New York, US; J.S. Hyde et al.: "Planar-pair local coils

(73) Patentinhaber: Siemens Aktiengesellschaft,
Wittelsbacherplatz 2, D-8000 München 2(DE)

(72) Erfinder: Dürr, Wilhelm, Dr., Damaschkestrasse 99,
D-8520 Erlangen(DE)
Erfinder: Krause, Norbert, Dr., Weinbergstrasse 29,
D-8551 Heroldsbach(DE)
Erfinder: Ingwersen, Hartwig, Dr., Zum Tennenbach 23,
D-8525 Uttenreuth(DE)
Erfinder: Oppelt, Ralph, Dr., Lindenweg 1,
D-8525 Uttenreuth(DE)

(56) Entgegenhaltungen: (Fortsetzung)
for high-resolution magnetic resonance imaging,
particularly of the temporomandibular joint"

## Beschreibung

Die Erfindung bezieht sich auf einen Oberflächenresonator zur Kernspintomographie mit einer Spule aus einer einzigen Windung eines bandförmigen elektrischen Leiters, bei dem die Kapazität zwischen den Enden die Resonanzfrequenz bestimmt.

Es ist bekannt, daß man die an Wasser gebundenen Wasserstoffatomkerne, d.h. Protonen, eines Untersuchungsobjektes aus einer Vorzugsrichtung, die durch ein magnetisches Grundfeld hoher statischer Feldstärke erzeugt wird, durch hochfrequente Anregungsimpulse zur Präzession anregen kann. Nach dem Ende eines Anregungsimpulses präzedieren die Atomkerne mit einer Frequenz, die von der Stärke des Grundfeldes abhängt und pendeln sich dann aufgrund ihres Spins nach einer vorbestimmten Relaxationszeit wieder in die Vorzugsrichtung ein. Durch rechnerische oder meßtechnische Analyse der integralen Protonensignale kann aus der räumlichen Spindichte oder der Verteilung der Relaxationszeiten innerhalb einer Körperschicht ein Bild erzeugt werden. Die Zuordnung des infolge der Präzesionsbewegung nachweisbaren Kernresonanzsignals zum Ort seiner Entstehung erfolgt durch die Anwendung linearer Feldgradienten. Diese Gradientenfelder werden dem Grundfeld überlagert und so gesteuert, daß nur in der abzubildenden Schicht eine Anregung der Protonen erfolgt. Diese Bilddarstellung ist bekannt unter der Bezeichnung Kernspin-Tomographie KST oder NMR-Tomographie (nuclear magnetic resonance).

Zur Abbildung gewisser Körperbereiche mit verhältnismäßig geringer Ausdehnung können bekanntlich sogenannte Oberflächenspulen verwendet werden, die im allgemeinen mit einer Vielzahl von Windungen als Flachspulen ausgebildet sind. Sie werden einfach auf das abzubildende Körperteil, beispielsweise einen Wirbel, das Mittelohr oder auch ein Auge, aufgelegt. Eine besondere Ausführungsform einer solchen Oberflächenspule besteht aus einem sogenannten "loop-gap"-Resonator. Die Spule besteht aus einer einzigen Windung eines bandsförmigen metallischen Leiters, dessen lappenförmige Enden einen Kondenstor bilden. Der Leiter wird im allgemeinen als Oberflächenschicht auf einen Träger aus elektrisch isolierendem Material aufgebracht, der im allgemeinen aus Kunststoff oder auch aus Plexiglas besteht. Durch den Abstand und die Größe der plattenförmigen Enden sowie durch ein Dielektrikum kann die Kapazität verändert werden, die mit der Induktivität des hohlzylindrischen Leiters in Resonanz gebracht wird. Die Energie kann durch eine Koppelschleife induktiv eingekoppelt werden (Journal of Magnetic Resonanz 61, Seiten 571 bis 578 (1985)).

Ferner ist ein Mikrowellen-Resonator in der Form eines Schlitzring-Resonators (split-ring) aus einem bandförmigen elektrischen Leiter bekannt, der eine zylindrische Spule mit einer Windung bildet, die mit wenigstens einem axialen Schlitz versehen ist. Die Kapazität der einander gegenüberstehenden Enden bestimmt die Resonanzfrequenz (US-Patent 4 446 429).

Der abgebildete Körperbereich wird durch die kreisförmige Querschnittsfläche des Resonators bestimmt. Aufgrund der Achsensymmetrie fällt der abgebildete Körperbereich stets gleich groß aus, unabhängig davon, ob die vom Rand der Leiterschleife eingeschlossene Boden- oder Deckfläche des Resonators der Körperoberfläche zugewandt wird. Zur Abbildung unterschiedlich großer Objektbereiche sind somit Oberflächenresonatoren mit entsprechend unterschiedlich großen Querschnittsflächen erforderlich.

Der Erfindung liegt nun die Aufgabe zugrunde, unterschiedlich große Körperbereiche eines Patienten mit ein und derselben Oberflächenspule abzubilden. Dabei soll stets eine hohe Lastgüte erreicht werden.

Diese Aufgabe wird erfindungsgemäß gelöst mit dem kennzeichnenden Merkmal des Anspruchs 1. Da die Boden- und Deckfläche des Kegelstumpfs unterschiedlich groß sind, können mit demselben Resonator zwei unterschiedlich große Objek    tbereiche abgebildet werden, je nachdem, ob Boden- oder Deckfläche der Körperoberfläche des Patienten zugewandt wird.

Zur weiteren Erläuterung der Erfindung wird auf die Zeichnung Bezug genommen, in der zwei Ausführungsbeispiele von Oberflächenresonatoren gemäß der Erfindung schematisch veranschaulicht sind.

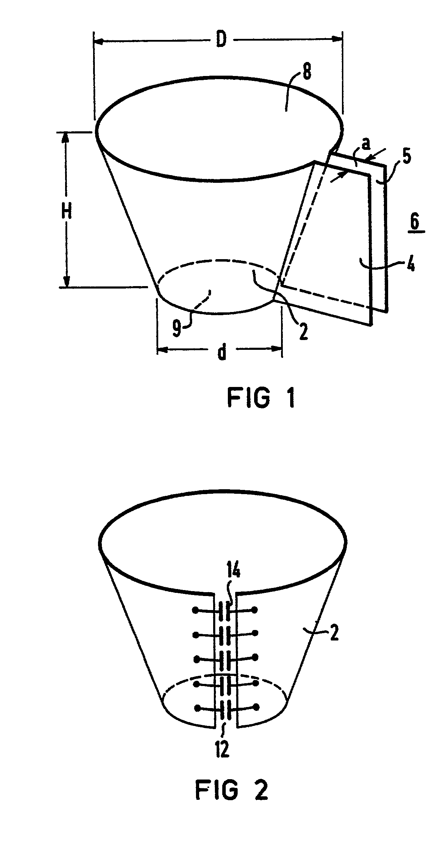

In der Ausführungsform gemäß Figur 1 besteht der Oberflächenresonator aus einer Spule 2 mit einer einzigen Windung in der Form eines Kegelstumpfs, dessen Enden 4 und 5 jeweils eine Platte eines Kondensators 6 mit einer Höhe H von beispielsweise etwa 8 cm bilden. Die vom oberen Rand der Spule 2 eingeschlossene Deckfläche 8 mit einem Durchmesser D von beispielsweise 10 cm ist wesentlich größer als die vom unteren Rand eingeschlossene Bodenfläche 9 mit einem Durchmesser d von beispielsweise etwa 5 cm. Mit diesem Oberflächenresonator können somit Körperteile mit unterschiedlicher Ausdehnung durch Kernspintomographie abgebildet werden.

Gemäß Figur 2 bilden die Enden der ebenfalls als Kegelstumpf geformten Spule 2 einen Schlitz 12, der mit Kapazitäten 14 versehen ist, welche über die Höhe der Spule gleichmäßig verteilt sind und deren Zuleitungen beispielsweise am Außenmantel der Spule 2 befestigt, vorzugsweise festgelötet oder auch festgeschraubt, sein können.

## Patentansprüche

1. Oberflächenresonator zur Kernspintomographie mit einer Spule (2) aus einer einzigen Windung eines bandförmigen elektrischen Leiters, dessen plattenförmige Enden (4, 5) einen Kondensator (6) bilden, dessen Kapazität die Resonanzfrequenz bestimmt, **gekennzeichnet** durch eine Form der Spule (2) als Mantel eines Kegelstumpfs.

2. Oberflächenresonator zur Kernspintomographie mit einer Spule (2) aus einer einzigen Windung eines bandförmigen elektrischen Leiters, bei dem die Kapazität zwischen den einander gegenüberstehenden Enden die Resonanzfrequenz bestimmt, **ge-**

**kennzeichnet** durch eine Form der Spule (2) als Mantel eines Kegelstumpfs.

**Revendications**

1. Résonateur de surface pour la tomographie à spin nucléaire, comportant une bobine (2) faite d'une spire unique en un conducteur électrique en forme de bande, et dont les extrémités, en forme de plaques (4, 5) forment un condensateur (6) dont la capaoité détermine la fréquence de résonance, caractérisé par une forme de la bobine (2) qui est celle de la surface latérale d'un tronc de cône.

2. Résonateur de surface pour la tomographie à spin nucléaire, comportant une bobine (2) faite d'une spire unique en un conducteur électrique en forme de bande, dans lequel la capacité entre les extrémités qui se font face déterminent la fréquence de résonance, caractérisé par une forme de la bobine (2) qui est celle de la surface latérale d'un tronc de cône.

**Claims**

1. Surface resonator for nuclear spin tomography having an inductor (2) comprising a single turn of a ribbon-shaped electrical conductor, the plate-shaped ends (4, 5) of which form a capacitor (6) whose capacitance determines the resonant frequency, characterised by the shape of the inductor (2) being like the surface of a truncated cone.

2. Surface resonator for nuclear spin tomography having an inductor (2) comprising a single turn of a ribbon-shaped electrical conductor, in which the capacitance between the ends opposite each other determines the resonance frequency, characterised by the shape of the inductor (2) being like the surface of a truncated cone.

EP 0 268 083 B1

FIG 1

FIG 2